Europäisches Patentamt

European Patent Office

Office européen des brevets

(19)

(11) **EP 0 772 289 A1**

(12) # DEMANDE DE BREVET EUROPEEN

(43) Date de publication:
**07.05.1997 Bulletin 1997/19**

(51) Int. Cl.$^6$: **H03D 3/24**

(21) Numéro de dépôt: **96202970.8**

(22) Date de dépôt: **24.10.1996**

(84) Etats contractants désignés:
**DE ES FR GB IT**

(30) Priorité: **31.10.1995 FR 9512865**

(71) Demandeurs:
• **PHILIPS COMPOSANTS ET
SEMICONDUCTEURS
92150 Suresnes (FR)**
Etats contractants désignés:
**FR**

• **Philips Electronics N.V.
5621 BA Eindhoven (NL)**
Etats contractants désignés:
**DE ES GB IT**

(72) Inventeur: **Lemasson, Pascal,
Société Civile S.P.I.D.
75008 Paris (FR)**

(74) Mandataire: **Caron, Jean
Société Civile S.P.I.D.
156, Boulevard Haussmann
75008 Paris (FR)**

(54) **Dispositif, de type boucle à verrouillage de phase, pour la démodulation d'un signal modulé en fréquence**

(57) Dispositif de démodulation en fréquence utilisant une boucle à verrouillage de phase.

Selon l'invention, pour rendre linéaire la variation de la fréquence d'un oscillateur local (11) en fonction de son signal de commande (Vb), une capacité variable (Cv) est formée par un module électronique (20) qui fournit l'équivalent d'une capacité dont la variation en fonction de la tension de commande (Vb) présente un écart de linéarité établi pour compenser l'écart de linéarité de la fréquence de l'oscillateur en fonction de la valeur de la capacité (Cv).

Application : démodulation de signaux modulés en fréquence, notamment de signaux de télévision émis par satellites.

FIG.1

EP 0 772 289 A1

## Description

La présente invention concerne un dispositif de démodulation d'un signal modulé en fréquence, du type utilisant une boucle à verrouillage de phase, comportant entre-autres un oscillateur qui fournit un signal de sortie dont la fréquence est réglable par une tension de commande, et un comparateur de phase à deux entrées, une entrée recevant le signal à démoduler et l'autre entrée recevant le signal de sortie de l'oscillateur, comparateur de phase qui délivre en sortie un signal à des moyens de filtrage lesquels fournissent la dite tension de commande de l'oscillateur, ainsi qu'un signal de sortie pour le dispositif de démodulation.

Un tel dispositif est connu entre autre par le document FR-A-2 556 526, dans lequel le principe, les avantages et les inconvénients de ce type de circuit sont comparés à un autre type de circuit démodulateur qui utilise uniquement un filtre et un comparateur de phase.

Les exigences relatives à la qualité d'une démodulation de fréquence concernent principalement l'absence de distorsion du signal démodulé. Des exigences particulièrement sévères s'appliquent à la démodulation d'un signal de télévision, par exemple un signal transmis par satellite, du fait qu'un défaut de linéarité génère alors des produits d'intermodulation entre les sous-porteuses de son et/ou entre une sous-porteuse de son et le signal de chrominance. Ce défaut fait apparaître dans le spectre de la vidéofréquence démodulée, des raies parasites produisant sur l'image des moirures particulièrement gênantes. Pour éviter ce genre de défaut, il est demandé que, dans la plage utile des fréquences utilisées, la dérivée de la tension du signal de sortie par rapport à la fréquence du signal d'entrée ne varie pas de plus de $\pm 1\%$.

Une telle performance de linéarité est atteinte d'autant plus difficilement que l'excursion de fréquence du signal à démoduler est plus étendue. Lorsque cette excursion représente 10% ou plus, de la fréquence centrale de travail, une démodulation à faible distorsion devient très difficile étant donné que la réponse en fréquence de l'oscillateur réglable par tension, n'est pas une fonction linéaire de sa tension de commande.

Aussi, l'un des buts de l'invention est-il de proposer un dispositif de démodulation présentant une linéarité de fonctionnement améliorée dans une plage de variations de fréquence du signal d'entrée relativement étendue, de l'ordre de $\pm$ 10% de la fréquence centrale du signal.

Le dispositif démodulateur selon l'invention est caractérisé en ce que l'oscillateur comprend un circuit résonant du type formé par une association en parallèle d'une inductance, d'une capacité fixe et d'une capacité variable laquelle est formée par un module électronique couplé à au moins un condensateur fixe et fournit l'équivalent d'une capacité variable dont la valeur, en fonction de la tension de commande qui est appliquée au dit module, présente un écart de linéarité établi pour compenser, dans une plage de fréquence fixée, un écart de linéarité de la réponse en fréquence de l'oscillateur en fonction de la valeur de la capacité variable.

Le dispositif de démodulation selon l'invention utilise donc un module électronique en tant que capacité variable, capacité dont la valeur obéit à une loi précise par rapport à la tension de commande qui est appliquée à ce module. En prévoyant une relation non linéaire entre la tension de commande et la valeur de la capacité variable, l'invention permet de rendre linéaire la réponse en fréquence de l'oscillateur en fonction de cette tension de commande, ceci au moins dans une plage de fréquences balayée par le signal modulé en fréquence. Par un réglage approprié, une compensation pratiquement parfaite peut être obtenue pour générer une fréquence de l'oscillateur qui soit linéaire en fonction de la tension de commande. A défaut d'une compensation parfaite, il est toujours possible, par réglage, d'obtenir un point d'inflexion dans la courbe de réponse en fréquence de l'oscillateur en fonction de sa tension de commande, et de placer ce point d'inflexion au voisinage de la fréquence centrale du signal à démoduler. Dans une plage de variations utile autour de cette fréquence centrale, une compensation de linéarité très satisfaisante peut être obtenue.

A titre de capacité variable, l'un des montages connus basé sur un couplage avec un ou plusieurs condensateurs fixes, peut être utilisé pour fournir l'équivalent d'une capacité variable dont la valeur varie de manière précise et reproductible avec un signal de commande approprié.

Selon un mode préféré de mise en oeuvre de l'invention, le dispositif est caractérisé en ce que le module électronique comporte un amplificateur du type à transconductance, à sortie différentielle, et une cellule de Gilbert couplée symétriquement à deux condensateurs fixes, et en ce que l'amplificateur est chargé en sortie par des diodes, dont la tension est appliquée aux entrées de la cellule de Gilbert.

L'utilisation d'une cellule de Gilbert pour réaliser l'équivalent d'une capacité variable offre des avantages particuliers en ce qui concerne la précision et la reproductibilité des résultats.

Les éléments formant cette cellule sont aisément intégrables, de même que les condensateurs fixes lorsque la fréquence du signal à démoduler est suffisamment élevée et permet alors l'utilisation de condensateurs de quelques pF seulement. Lorsque les condensateurs sont intégrés en même temps que le dispositif de démodulation, la mise en oeuvre de ce dispositif s en trouve d'autant simplifiée.

Pour appliquer la correction de linéarité recherchée, une fonction du type conique peut être mise en oeuvre, par exemple une fonction parabolique dont la croissance est positive. Toutefois, dans un mode préféré de réalisation, le dispositif selon l'invention est caractérisé en ce que la loi de variation de la capacité variable en fonction de la tension de commande est de type hyperbolique.

Une correction de ce type est en effet parfaitement adaptée pour linéariser la réponse en fréquence de l'oscillateur. Par ailleurs un amplificateur qui présente une fonction de transfert hyperbolique est non seulement facile à réaliser sous forme de circuit intégré, mais également permet de disposer d'un nombre suffisant de paramètres pour que la fonction réalisée soit la mieux adaptée à la correction de linéarité recherchée.

Selon un mode de réalisation pratique de l'invention, et pour réaliser une fonction de transfert de l'amplificateur qui soit de type hyperbolique, le dispositif de démodulation est caractérisé en ce que l'amplificateur comporte un étage différentiel de sortie formé d'une paire de transistors dont les électrodes de sortie sont connectées aux dites diodes, dont les électrodes de référence sont d'une part couplées entre elles via une résistance de linéarisation, et d'autre part, alimentées par deux sources de courant, en ce qu'il comporte deux étages d'entrée recevant chacun ladite tension, un premier étage d'entrée d'un type différentiel à fonction de transfert sensiblement linéaire, dont des sorties complémentaires en tension sont couplées aux entrées de l'étage de sortie, et un deuxième étage d'entrée, également à fonction de transfert sensiblement linéaire, dont une sortie unique en tension fournit une commande proportionnelle du courant délivré par les deux sources de courant alimentant l'étage de sortie.

De plus, le premier et le deuxième étages d'entrée de l'amplificateur présentent chacun une tension de décalage prédéterminée.

Selon ce mode de mise en oeuvre, on dispose de quatre paramètres de réglage pour réaliser la fonction de transfert la mieux adaptée, paramètres dont trois seulement sont réellement indépendants.

L'invention concerne également un appareil de réception de signaux de télévision, par exemple un appareil dit décodeur de signaux transmis par satellite, caractérisé en ce qu'il comporte un dispositif de démodulation selon l'invention et tel que défini précédemment.

La description qui va suivre en regard des dessins annexés, donnée à titre d'exemple non limitatif, fera bien comprendre en quoi consiste l'invention et comment elle peut être réalisée.

La figure 1 représente un schéma général d'un dispositif de démodulation du type boucle à verrouillage de phase, à l'aide duquel l'invention sera décrite dans son principe,

la figure 2 présente des courbes de capacité et de fréquence en fonction d'une tension de commande dans le cas où aucune correction n'est appliquée à cette tension de commande tandis qu'à la figure 3 sont présentées des courbes analogues obtenues conformément à la mise en oeuvre de l'invention,

la figure 4 montre le schéma électrique d'un montage à cellule de Gilbert équivalent à une capacité variable ainsi que d'un amplificateur introduisant une correction non linéaire d'un signal de commande de cette capacité variable, et

la figure 5 est un schéma simplifié d'un appareil de réception incorporant un circuit de démodulation de fréquence selon l'invention.

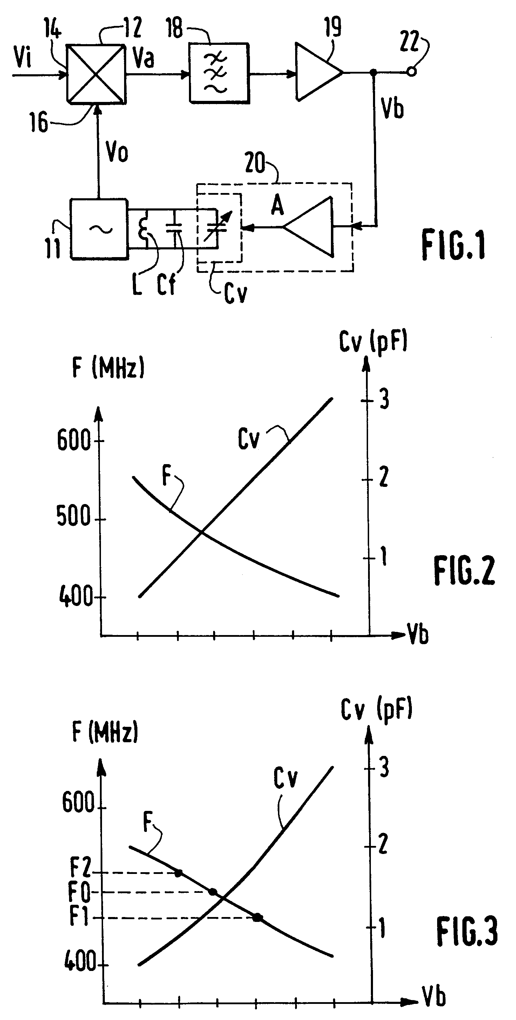

La figure 1 décrit schématiquement un dispositif du type boucle à verrouillage de phase pour la démodulation d'un signal modulé en fréquence. Ce dispositif comporte un oscillateur 11 qui fournit un signal de sortie Vo, un comparateur de phase 12 à deux entrées, une entrée 14 recevant un signal Vi à démoduler et une entrée 16 recevant le signal Vo issu de l'oscillateur 11. L'oscillateur 11 comprend un circuit résonnant du type formé par une association en parallèle d'une inductance L d'une capacité fixe Cf et d'une capacité variable Cv laquelle est réalisée au moyen d'un module électronique 20 fournissant l'équivalent d'une capacité variable en fonction d'une tension de commande Vb appliquée audit module 20.

La tension de commande Vb de l'oscillateur 11 est fournie à une borne de sortie 22 du dispositif de démodulation. Cette tension Vb est déduite d'une tension Va obtenue en sortie du comparateur de phase 12 après filtrage dans un filtre passe-bas 18 qui assure la stabilité de la boucle à verrouillage de phase, et après amplification dans un amplificateur 19.

De manière à obtenir une bonne linéarité entre le signal de commande Vb et la fréquence du signal Vo de sortie de l'oscillateur 11, il est prévu selon l'invention que la valeur de la capacité variable Cv en fonction de la tension de commande Vb qui est appliquée au module 20 présente un écart de linéarité qui est choisi pour compenser, dans la plage de fréquences à laquelle on s'intéresse, un écart de linéarité de la réponse en fréquence de l'oscillateur 11, en fonction de la valeur de cette capacité variable Cv.

Un défaut de linéarité de la réponse en fréquence de l'oscillateur 11 est représenté à la figure 2. On a supposé qu'une capacité variable Cv variait de manière linéaire en fonction de la tension de commande Vb, portée sur l'axe des abscisses. Dans l'exemple, cette capacité Cv varie de 0,5 à 3 pF et est connectée en parallèle avec une capacité fixe d'environ 2,5 pF. La fréquence F obtenue par l'oscillateur 11 varie entre 550 et 410 MHz. La courbe F de la fréquence présente une fonction qui s'écarte d'une droite et est légèrement incurvée.

La figure 3 présente l'effet obtenu selon l'invention, par le module électronique 20 à correction non linéaire. Selon l'invention, la courbe Cv de capacité variable en fonction de la tension de commande Vb présente un écart de linéarité par comparaison avec la courbe correspondante de la figure 2. Cet écart est déterminé pour que la courbe de fréquence F de l'oscillateur devienne linéaire au moins dans une plage de fréquence F1-F2 autour d'une fréquence centrale F0.

Un module électronique tel que le module 20 de la figure 1 peut être réalisé de différentes manières. Il repose sur l'utilisation d'au moins un condensateur de valeur fixe qui, incorporé à ce module, fournit un effet équivalent à une capacité variable. Il comporte un amplificateur A à transistors commandant la variation de la capacité variable équivalente selon une fonction non linéaire par rapport à la tension Vb appliquée à l'entrée de cet amplificateur A.

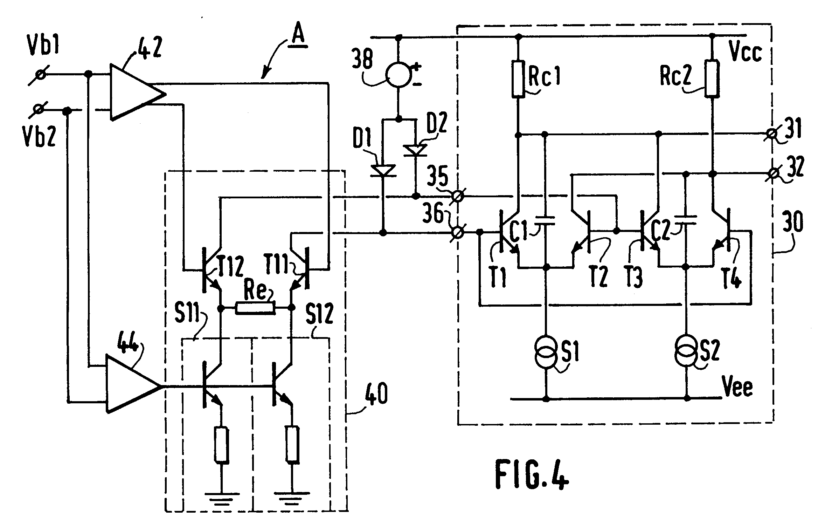

La figure 4 montre un schéma électrique détaillé d'un exemple de réalisation d'un module électronique tel que le module 20 de la figure 1.

Dans cet exemple de réalisation, la capacité variable est réalisée au moyen d'une cellule de Gilbert 30 composée des paires de transistors T1-T2, T3-T4 dont les émetteurs réunis dans chaque paire, sont alimentés respectivement par la source de courant S1 et par la source de courant S2. Le collecteur du transistor T1 est relié au collecteur du transistor T3 l'ensemble étant couplé à une ligne d'alimentation Vcc par une résistance de charge Rc1. De manière symétrique, le collecteur du transistor T2 est relié au collecteur du transistor T4 l'ensemble étant couplé à la ligne Vcc par une résistance de charge Rc2.

Les bases réunies des transistors T2 et T3 sont reliées à une première borne d'entrée 35 de la cellule de Gilbert alors que les bases réunies des transistors T1 et T4 sont reliées à une deuxième borne d'entrée 36. Un condensateur fixe C1 relie le collecteur du transistor T1 à son émetteur, et un autre condensateur fixe C2 relie le collecteur du transistor T4 à son émetteur.

La cellule de Gilbert 30 est commandée par un amplificateur A débitant en sortie sur une charge constituée par des diodes D1, D2 dont les anodes réunies sont couplées à la ligne d'alimentation Vcc par l'intermédiaire d'un dispositif de décalage de tension 38.

L'amplificateur A est de type à transconductance et comporte un étage différentiel de sortie formé d'une paire de transistors T11, T12 dont les collecteurs sont reliés respectivement aux cathodes des diodes D1 et D2 ainsi qu'aux bornes d'entrée 35 et 36 de la cellule de Gilbert 30.

Les émetteurs des transistors T11 et T12 sont couplés par une résistance d'émetteur Re et sont alimentés chacun respectivement par une source de courant S11, S12 susceptible de débiter un courant variable qui reste identique entre les deux sources de courant.

L'amplificateur A comporte également deux étages d'entrée, un premier étage 42 de type différentiel à fonction de transfert sensiblement linéaire dont les sorties sont couplées aux bases des transistors T11 et T12 et un deuxième étage d'entrée 44 de type différentiel à fonction de transfert sensiblement linéaire dont une sortie unique commande les bases des transistors constituant resepctivement les sources de courant S11 et S12 et réalise ainsi la commande de courant de ces sources de courant.

Les étages d'entrée 42 et 44 reçoivent en parallèle les tensions d'entrée Vb1 et Vb2 représentant sous forme différentielle la tension de commande Vb dont il a été question à propos de la figure 1.

Les deux étages d'entrée 42 et 44 sont prévus chacun avec une tension de décalage déterminée. L'étage d'entrée 44 présente une tension de décalage telle que pour un signal Vb = Vb1 - Vb2 = 0 , les sources de courant S11 et S12 débitent un courant de repos Ir tandis que pour une tension d'entrée Vb1 - Vb2 différente de 0, le courant Iee des sources de courant S11 et S12 est de la forme : Iee = Ir + k1.Vb . La tension de décalage de l'étage d'entrée 42 est prévue telle que pour une tension d'entrée Vb1 - Vb2 nulle, le transistor T11 débite un courant plus élevé que le courant débité par le transistor T12.

En négligeant les courants de base, on peut écrire que le courant collecteur Ic11 du transistor T11 est de la forme

$$Ic11 = k2.(Vb + \Delta V)/Re + Iee \qquad (1)$$

avec

$$Iee = k1.Vb + Ir \qquad (2)$$

c'est-à-dire d'une forme linéaire par rapport à Vb
expressions dans lesquelles
k2 est un coefficient lié au gain du premier étage d'entrée 42 et $\Delta V$ est la tension de décalage de cet étage.
On a par ailleurs :

$$Ic11 + Ic12 = 2.Iee = 2.(k1.Vb + Ir) \qquad (3)$$

c'est-à-dire que la somme des courants collecteur des transistors T11 et T12 est égale à la somme des courants des sources S11 et S12.

La différence de tension (VD1 - VD2) aux bornes des diodes D1 et D2 peut s'écrire :

$$VD1 - VD2 = V_T \, Ln \, (Ic11/Ic12) \qquad (4)$$

avec $V_T \approx 26$ mV à 300°K.

Cette différence de tension, appliquée aux bornes d'entrée de la cellule de Gilbert 30, entraîne que les courants collecteurs lc1 et lc2 dans les transistors T1 et T2 seront définis par

$$VD1 - VD2 = V_T \, Ln \, ( \, lc2/lc1) \tag{5}$$

Il s'ensuit en comparant (4) et (5) que :

$$\frac{lc2}{lc1} = \frac{lc11}{lc12}$$

soit encore, en utilisant les relations (1), (2) et (3)

$$\frac{lc2}{lc1+lc2} = \frac{lc11}{lc11+lc12}$$
$$= \frac{k1Vb+Ir+k2.VbIRe+k2\Delta VIRe}{2k1.Vb+2Ir}$$

$$lc2 = (lc1+lc2) \, . \, \frac{(k1+k2IRe).Vb + k2\Delta VIRe + Ir}{2k1.Vb + 2Ir} \tag{6}$$

La relation (6) montre que lc2 est de la forme hyperbolique :

$$\frac{aVb+b}{cVb+d}$$

et peut être ajusté au moyen de trois paramètres indépendants pour s'adapter au mieux à la forme de courbe recherchée.

Dans l'exemple de la figure 4, on peut choisir à volonté : le gain du premier étage d'entrée 42, le gain du deuxième étage d'entrée 44, les tensions de décalage de chacun de ces étages d'entrée.

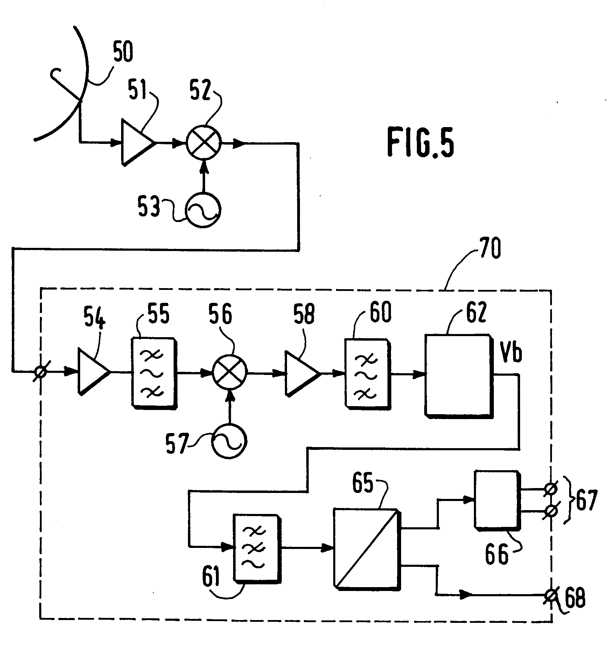

La figure 5 est un schéma bloc d'un exemple d'appareil de réception incorporant un dispositif de démodulation tel qu'il a été décrit précédemment. Une antenne 50 à réflecteur parabolique reçoit des signaux en provenant d'un satellite émis sous une fréquence de 10 à 12 GHz. Après amplification dans un amplificateur d'antenne 51 les signaux reçus sont appliqués à un premier mixeur 52 recevant par ailleurs le signal d'un premier oscillateur 53 dont la fréquence est choisie pour fournir en sortie de ce premier mixeur 52 une gamme de fréquences comprise entre 920 et 2150 MHz. Les éléments 51, 52 et 53 sont situés au niveau de l'antenne 50 et ont été représentés séparés de celle-ci uniquement pour une meilleure clarté de la figure.

L'appareil de réception proprement dit est délimité par un cadre 70 en tirets. Il possède un amplificateur d'entrée 54, suivi d'un filtre passe-bande 55 assurant une présélection des canaux à recevoir. A la sortie de ce filtre 55, le signal est à nouveau combiné dans un deuxième mixeur 56 avec le signal produit par un deuxième oscillateur 57 de manière à produire un signal à une fréquence intermédiaire de l'ordre de 480 MHz.

Le signal à fréquence intermédiaire est amplifié dans un amplificateur 58 muni d'un contrôle automatique de gain, puis filtré dans un filtre passe-bande 60 et appliqué à l'entrée d'un dispositif de démodulation de fréquence 62 conforme à l'invention. Il délivre une tension de sortie Vb représentant le signal de réception démodulé. A l'aide du dispositif de démodulation conforme à l'invention, il est possible d'obtenir une réponse en fréquence dont la linéarité est excellente, correspondant à une valeur de produits d'intermodulation de -55dBc pour le deuxième ordre et de -60dBc pour le troisième ordre.

Le signal Vb dit vidéo-composite est traité dans un filtre de désaccentuation 64 à la sortie duquel un circuit de séparation 65 effectue l'extraction des signaux de son, démodulés dans un démodulateur 66, et disponibles aux sorties 67 de l'appareil, tandis que les signaux d'image composés de signaux de luminance et chrominance sont acheminés à une sortie 68.

Bien entendu, l'appareil de réception décrit ici brièvement, à titre d'exemple, pour illustrer la mise en oeuvre de l'invention, pourrait présenter une organisation quelque peu différente sans sortir du cadre de l'invention. Des modifications à ce sujet sont à la portée du spécialiste.

## Revendications

1. Dispositif de démodulation d'un signal modulé en fréquence, du type utilisant une boucle à verrouillage de phase, comportant entre-autres un oscillateur qui fournit un signal de sortie dont la fréquence est réglable par une tension de commande, et un comparateur de phase à deux entrées, une entrée recevant le signal à démoduler et l'autre entrée recevant le signal de sortie de l'oscillateur, comparateur de phase qui délivre en sortie un signal à des moyens de filtrage lesquels fournissent la dite tension de commande de l'oscillateur, ainsi qu'un signal de sortie pour le dispositif de démodulation,
caractérisé en ce que l'oscillateur comprend un circuit résonant du type formé par une association en parallèle d'une inductance, d'une capacité fixe et d'une capacité variable laquelle est formée par un module électronique couplé à au moins un condensateur fixe et fournit l'équivalent d'une capacité variable dont la valeur, en fonction de la tension de commande qui est appliquée au dit module, présente un écart de linéarité établi pour compenser, dans une plage de fréquence fixée, un écart de linéarité de la réponse en fréquence de l'oscillateur en fonction de la valeur de la capacité variable.

2. Dispositif de démodulation selon la revendication 1, caractérisé en ce que le module électronique comporte un amplificateur du type à transconductance à sortie différentielle et une cellule de Gilbert couplée symétriquement à deux condensateurs fixes, et en ce que l'amplificateur est chargé en sortie par des diodes, dont la tension est appliquée aux entrées de la cellule de Gilbert.

3. Dispositif de démodulation selon la revendication 2, caractérisé en ce que la loi de variation de la capacité variable en fonction de la tension de commande est de type hyperbolique.

4. Dispositif de démodulation selon la revendication 3, caractérisé en ce que l'amplificateur comporte un étage différentiel de sortie formé d'une paire de transistors dont les électrodes de sortie sont connectées aux dites diodes, dont les électrodes de référence sont d'une part couplées entre elles via une résistance de linéarisation, et d'autre part, alimentées par deux sources de courant, en ce qu'il comporte deux étages d'entrée recevant chacun ladite tension de commande, un premier étage d'entrée d'un type différentiel à fonction de transfert sensiblement linéaire, dont des sorties complémentaires en tension sont couplées aux entrées de l'étage de sortie, et un deuxième étage d'entrée, également à fonction de transfert sensiblement linéaire, dont une sortie unique en tension fournit une commande proportionnelle du courant délivré par les deux sources de courant alimentant l'étage de sortie.

5. Dispositif de démodulation selon la revendication 4, caractérisé en ce que le premier et le deuxième étage d'entrée de l'amplificateur présentent chacun une tension de décalage prédéterminée.

6. Appareil de réception de signaux de télévision, caractérisé en ce qu'il comporte un dispositif de démodulation selon l'une quelconque des revendications 1 à 5.

FIG.1

FIG.2

FIG.3

FIG.4

FIG.5

Office européen
des brevets

**RAPPORT DE RECHERCHE EUROPEENNE**

Numero de la demande

EP 96 20 2970

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | US 4 612 511 A (NAITO MICHINORI ET AL) 16 Septembre 1986<br>* colonne 1, ligne 61 - colonne 3, ligne 49; figures 2,3 *<br>--- | 1-3,6 | H03D3/24 |
| Y | DE 28 03 400 B (SIEMENS AG) 19 Juillet 1979<br>* colonne 1, ligne 51 - colonne 4, ligne 48; figures 1-3 *<br>--- | 1-3,6 | |
| A | US 4 132 964 A (WILCOX MILTON E) 2 Janvier 1979<br>* abrégé; figures 2-4 *<br>--- | 1 | |
| A | US 4 374 335 A (FUKAHORI KIYOSHI ET AL) 15 Février 1983<br>* abrégé; figures 1,2 *<br>--- | 2 | |
| P,X | EP 0 702 452 A (PLESSEY SEMICONDUCTORS LTD) 20 Mars 1996<br>* le document en entier *<br>----- | 1-6 | |

DOMAINES TECHNIQUES
RECHERCHES (Int.Cl.6)

H03D
H03B
H03L

Le présent rapport a été établi pour toutes les revendications

| Lieu de la recherche | Date d'achèvement de la recherche | Examinateur |
|---|---|---|
| LA HAYE | 31 Janvier 1997 | Dhondt, I |

EPO FORM 1503 03.82 (P04C02)